# EUROPEAN PATENT APPLICATION

(11) **EP 1 152 473 A1**
(43) Date of publication of application: **07.11.2001**
(21) Application number: 00109503.3
(22) Date of filing: 04.05.2000
(51) Int. Cl.: H01L 33/00

(54) **Bowl on lead frame in light emitting diode**

(71) Applicant: Yu, San-Hua, Tu Cheng, Taipei, Hsien (TW)
(72) Inventor: Yu, San-Hua, Tu Cheng, Taipei, Hsien (TW)
(74) Representative: Helms, Joachim, Dipl.-Ing. Patentanwalt

(57) **Abstract**

A bowl for a lead frame in a light emitting diode has a room with inner wall and the inner wall has a curved surface concave toward the center of the room. The light emitted can be concentrated as a beam of light by way of being reflected by the curved surface.

## Description

### BACKGROUND OF THE INVENTION

### 1. Field of The Invention:

The present invention relates to a bowl on a lead frame in a light emitting diode, and particularly to a bowl on a lead frame in a light emitting diode to prevent the light from divergence or diffusion.

### 2. Description of Related Art:

The diode is a kind of electronic element and has been used for years. Especially, the light emitting diode provides a feature of flashing such that it is frequently used for signaling or decorating. Because of the feature of flashing, the light emitting diode consumes less electricity so that a little bit power is enough for supplying the electricity needed by the light emitting diode. Therefore, the light emitting diode is widely adopted in the traffic indication rod, the third brake light on a car, Christmas decoration lights, and other light emitting device.

Usually the light emitting diode is made by the following steps: a conductive metal band is stamped to form semi-products and each semi-product has a couple of connecting legs, then, a dies or a chip is brazed to one of the connecting legs at the bowl thereon, the bowl connects the other connecting leg with a brazing line, and finally, the other end of each connecting leg is cut to constitute a long connecting leg and a short connecting leg. Generally, the long leg is used as a negative pole and the short leg is a positive pole. After the dies is placed in the bowl, the dies is sealed in place by glue. The long and the short legs are frame body such that they are called blank material or so called lead frames of the light emitting diode.

As mentioned above, in order to locate the dies, one of the lead frame at an end thereof is a bowl such that the dies can be brazed to the bowl and the bowl is sealed up by glue to perform the function of emitting light. However, divergence or diffusion will be generated while the light is emitted from the dies. Therefore, a poor light intensity is obtained undesirably.

### SUMMARY OF THE INVENTION

An object of the present invention is to provide a bowl for a lead frame in a light emitting diode, with which a divergency of light or a diffusion of light can be overcome completely.

### BRIEF DESCRIPTION OF THE DRAWINGS

The present invention can be more fully understood by referring to the following description and accompanying drawing, in which:
Fig. 1 is a plan view of a bowl for a lead frame in a light emitting diode of the present invention; and
Fig. 2 is a diagram of distribution for a measured light.

### DETAILED DESCRIPTION OF THE PREFERRED EMBODIMENTS

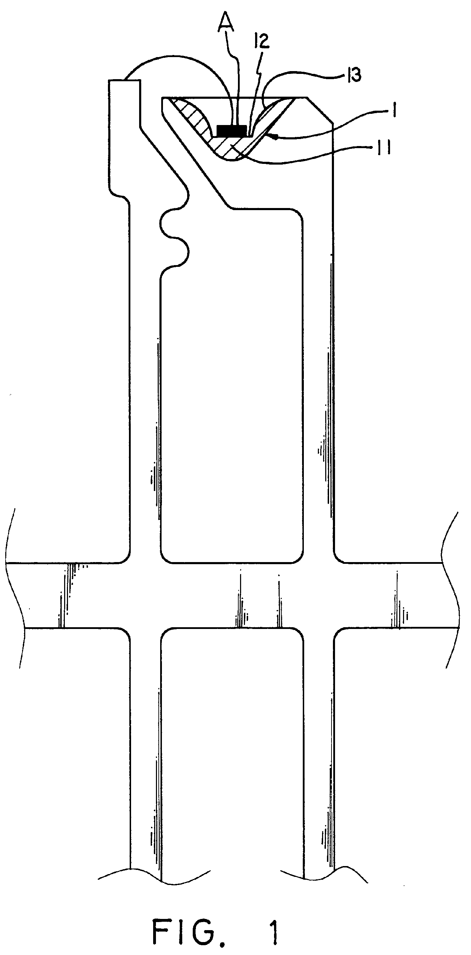

Referring to Fig. 1, a bowl **1** for a dies is provided on one of the lead frames at an end thereof and the bowl **1** has a conical space with an opening upward. A bowl bottom **11** of the bowl **1** has a flat surface **12** for locating the dies **A**.

Unlike the prior art, a conical wall of the bowl **1** is provided with a curved surface **13** concave toward the center of the space in the bowl such that the space is formed a trumpet room.

Referring to Fig. 1 again, after having been placed and located in the bowl **1**, the light emitted by the dies **A** is reflected by the curved surface **13** to constitute a gathered beam of light. Thus, the light emitted is concentrated to increase the light intensity accordingly.

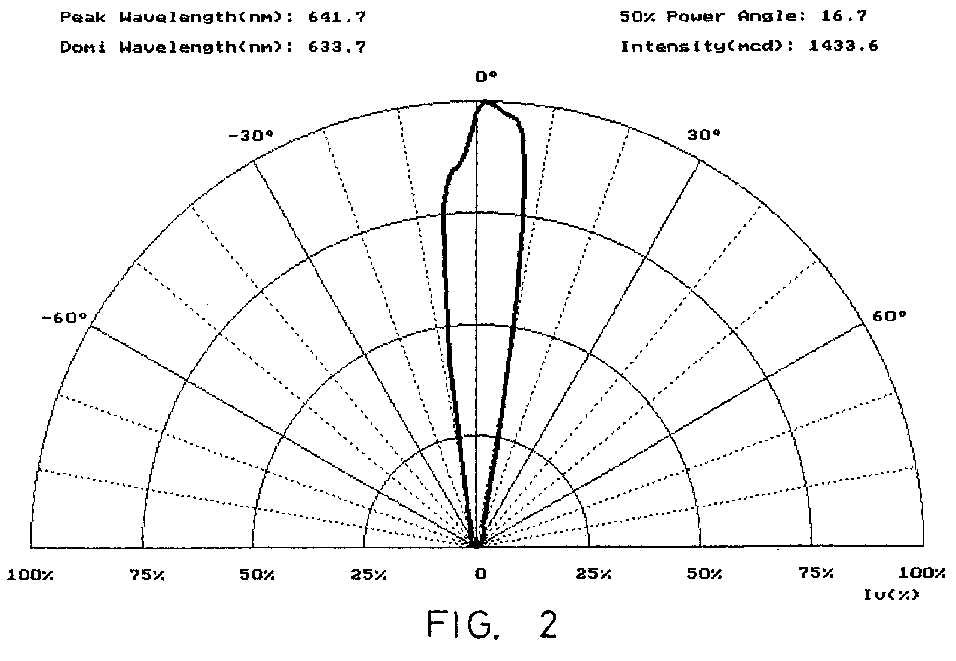

Referring to Fig. 2, a graph of the light intensity is measured from the light emitted via the bowl of the present invention. It can be seen that the graph is gathered at the vertical region and it means the light is concentrated at the central part while is emits out. Hence, it can be verified that a dies **A** is located in the bowl of the present invention will generate a best illumination. It is quite clearly that the superior result made by the bowl of the present invention is not possible for the prior art being able to achieve.

In addition, if a ellipsoid bowl is used instead of the cone bowl and the inner wall of the ellipsoid bowl is provided with curved surface as the cone bowl does, a concentrated light beam can be obtained as well to intensify the light. Because this is an equivalent effect, a detail will not described further.

While the invention has been described with reference to a preferred embodiment thereof, it is to be understood that modifications or variations may be easily made without departing from the spirit of this invention, which is defined by the appended claims.

## Claims

1. A bowl for a lead frame in a light emitting diode comprising
a room with inner wall, the inner wall having a curved surface concave toward the center of the room;
whereby, the light emitted can be concentrated as a beam of light by way of being reflected by the curved surface.

2. A bowl for a lead frame in a light emitting diode according to claim 1, wherein the bowl has a bottom of flat surface.

3. A bowl for a lead frame in a light emitting diode according to claim 1, wherein the bowl is cone shape.

4. A bowl for a lead frame in a light emitting diode according to claim 1, wherein the bowl is ellipsoid shape.
